# EUROPEAN PATENT APPLICATION

(11) **EP 4 617 846 A1**
(43) Date of publication of application: **17.09.2025**
(21) Application number: 23893166.1
(22) Date of filing: 30.06.2023
(51) Int. Cl.: G06F 3/06, G06F 16/174

(54) **DATA PROCESSING METHOD AND APPARATUS**

(30) Priority: 21.11.2022 CN 202211462945; 07.03.2023 CN 202310212957
(71) Applicant: Huawei Cloud Computing Technologies Co., Ltd., Guiyang, Guizhou 550025 (CN)
(72) Inventor: XIE, Weibin, Guiyang, Guizhou 550025 (CN); WANG, Daohui, Guiyang, Guizhou 550025 (CN); DING, Meng, Guiyang, Guizhou 550025 (CN); MEN, Yong, Guiyang, Guizhou 550025 (CN); WANG, Yang, Guiyang, Guizhou 550025 (CN)
(74) Representative: Gill Jennings & Every LLP
(86) International application number: PCT/CN2023/104582
(87) International publication number: WO 2024/109066

(57) **Abstract**

This application discloses a data processing method and an apparatus, and belongs to the field of storage technologies. The method includes: obtaining a plurality of to-be-compressed data blocks; combining the plurality of to-be-compressed data blocks; and compressing the plurality of combined to-be-compressed data blocks, to obtain a data set with combine compression. In this application, combine compression on data is applied, so that a data compression procedure is simplified, a data compression delay is effectively reduced, and data compression efficiency is improved.

## Description

This application claims priorities to Chinese Patent Application No. 202211462945.6, filed on November 21, 2022 and entitled "DATA COMPRESSION AND DECOMPRESSION METHOD AND APPARATUS", and to Chinese Patent Application No. 202310212957.1, filed on March 7, 2023 and entitled "DATA PROCESSING METHOD AND APPARATUS", both of which are incorporated herein by reference in their entireties.

### TECHNICAL FIELD

This application relates to the field of storage technologies, and in particular, to a data processing method and an apparatus.

### BACKGROUND

A data deduplication and compression technology is the most effective and direct method to reduce storage costs. The deduplication and compression technology based on similar data clustering can cluster similar data distributed in time and space in a system, to improve a data reduction ratio of the system.

Currently, the data deduplication and compression technology can cluster the similar data distributed very discretely and unevenly in time and space by sampling feature values, and the data is compressed by using a hierarchical data reduction technology. The hierarchical data reduction technology is used to search for identical data in the clustered similar data for deduplication, and in addition, is used to compress data in the clustered similar data by using a delta compression solution, to obtain delta blocks, and compress the delta blocks by using a deep compression algorithm, to further improve the reduction ratio.

However, a procedure of the data deduplication and compression technology is redundant, resulting in a large compression and decompression delay.

### SUMMARY

This application provides a data processing method and an apparatus. In this application, a data compression procedure is simplified, a data compression delay is effectively reduced, and data compression efficiency is improved. Technical solutions provided in this application are as follows.

According to a first aspect, this application provides a data processing method. The method includes: obtaining a plurality of to-be-compressed data blocks; combining the plurality of to-be-compressed data blocks; and compressing the plurality of combined to-be-compressed data blocks, to obtain a data set with combine compression.

When data compression is performed by using the data processing method, after the plurality of to-be-compressed data blocks are obtained, the plurality of to-be-compressed data blocks are combined, and then combine compression is performed on the plurality of combined to-be-compressed data blocks, to obtain the data set with combine compression. In this way, when data is compressed, combine compression on the data is applied, so that a data compression procedure is simplified, a data compression delay is effectively reduced, data compression efficiency is improved, and consumption of a resource (for example, a CPU) for compression is reduced.

In an implementation, the plurality of to-be-compressed data blocks are sequentially sorted, and a coding partition of any one of the plurality of to-be-compressed data blocks includes the any one to-be-compressed data block and all to-be-compressed data blocks that are in the plurality of to-be-compressed data blocks and that are sorted before the any one to-be-compressed data block. In this way, a data amount of the coding partition is increased. Because a data amount of a coding partition searched for redundant data during compression of a single data block is increased, utilization that is in time and space and that is of a sample for searching for redundant data of a to-be-compressed data block is improved, and a reduction ratio of compression is further improved, thereby further reducing storage costs.

Optionally, the compressing the plurality of combined to-be-compressed data blocks includes: compressing the plurality of combined to-be-compressed data blocks based on forward coding. In this way, a compression sequence of a compression algorithm can perfectly match a coding partition of each data block, which is more conducive to further improving a reduction ratio while maintaining low compression/decompression overheads. In addition, when a compression algorithm is selected, reference may be made to a compression ratio of the compression algorithm, to further ensure a compression ratio of compressed data, thereby ensuring storage costs of a storage system.

The to-be-compressed data block may be obtained according to a data write instruction. For example, in the storage field, a plurality of to-be-written data blocks may be obtained according to a data write instruction, and a plurality of to-be-compressed data blocks may be obtained based on the plurality of to-be-written data blocks. After the data set with combine compression is obtained, the method further includes: storing the data set in a storage medium.

After a location of each data block in the data set with combine compression in the storage medium is obtained, index information of the storage medium may be further updated based on the location, so that when data in the data set needs to be read, a corresponding data block can be located based on an index in the index information. The index information of the storage medium is used to record index information of all data stored in the storage system.

In an implementation, index information of the to-be-compressed data blocks may not only indicate a physical address of compressed data, but also indicate logical index numbers (logic-index) of compressed data blocks. The logical index numbers may be allocated to a plurality of to-be-compressed data blocks before compression is performed on the plurality of to-be-compressed data blocks.

Optionally, the index information further indicates that the data set is obtained through combine compression. Combine compression may be or may not be performed on the data stored in the storage system. The index information indicates that the data is obtained through combine compression, so that data with combine compression can be distinguished from data without combine compression.

Similarly, index information of a reserved to-be-filtered data block with deduplication may further indicate that the reserved to-be-filtered data block is obtained through deduplication. In this way, data with deduplication can be distinguished from data without deduplication in the storage system.

In an implementation, the plurality of to-be-compressed data blocks may be data blocks including similar data. Obtaining the plurality of to-be-compressed data blocks based on the plurality of to-be-written data blocks includes: obtaining a plurality of to-be-filtered data blocks based on the plurality of to-be-written data blocks; and obtaining the plurality of to-be-compressed data blocks based on to-be-filtered data blocks including similar data in the plurality of to-be-filtered data blocks.

In a storage scenario, to-be-written data may include data that needs to be compressed and data that does not need to be compressed. The obtaining a plurality of to-be-filtered data blocks based on the plurality of to-be-written data blocks includes: filtering the plurality of to-be-written data blocks for data blocks that need to be compressed, to obtain the plurality of to-be-filtered data blocks.

Optionally, the obtaining the plurality of to-be-compressed data blocks based on to-be-filtered data blocks including similar data in the plurality of to-be-filtered data blocks may include: after filtering the to-be-filtered data blocks including the similar data from the plurality of to-be-filtered data blocks, performing deduplication on the to-be-filtered data blocks including the similar data, to obtain the plurality of to-be-compressed data blocks.

In this case, the index information of the reserved to-be-filtered data block with deduplication further indicates that the reserved to-be-filtered data block is obtained through deduplication.

According to a second aspect, this application provides a data processing method. The method includes: obtaining index information of a to-be-decompressed target data set, where the target data set includes one or more data blocks, and the target data set is obtained through combine compression; obtaining the target data set based on the index information of the target data set; and performing combine decompression on the target data set, to obtain a target data set with combine decompression.

Data decompression is performed by using the data processing method. After the index information of the to-be-decompressed target data set is obtained, the target data set is obtained based on the index information of the target data set, and then combine decompression is performed on the target data set, to obtain the target data set with combine decompression. The target data set includes one or more data blocks, and the target data set is obtained through combine compression. In this way, when data is decompressed, combine decompression on the data is applied, so that a data decompression delay is effectively reduced, data decompression efficiency is improved, and consumption of a resource for decompression is reduced.

Optionally, the index information of the target data set further indicates a processing type of data in the target data set. The performing combine decompression on the target data set, to obtain a target data set with combine decompression includes: when the index information of the target data set indicates that the target data set is obtained through combine compression, performing combine decompression on the target data set, to obtain the target data set with combine decompression. In an implementation, a decompression method matching combine compression of the target data set may be used to perform combine decompression on the target data set. For example, when the target data set is obtained through combine compression based on forward coding, combine decompression may be performed on the target data set by using a decompression method matching the forward coding. In addition, when compression is performed on any one of a plurality of to-be-compressed data blocks that are sequentially sorted, if a coding partition of the any one to-be-compressed data block includes the any one to-be-compressed data block and all to-be-compressed data blocks that are in the plurality of to-be-compressed data blocks and that are sorted before the any to-be-compressed data block, decompression of the target data set can be completed by performing decompression only once during combine decompression.

In an implementation, the target data set is stored in a storage medium, both a primary index area and an online index area of the storage medium record index information, the primary index area records first index information of all data stored in the storage medium, the online index area records second index information, the first index information is obtained by updating the second index information, and the obtaining index information of a to-be-decompressed target data set includes: obtaining the index information of the target data set preferentially from the first index information recorded in the primary index area. The index information of the target data set is obtained preferentially from the first index information recorded in the primary index area, and the index information does not need to be obtained by accessing a compression module by using a metadata management module. This can reduce one map operation, reduce network overheads for searching for the index information, and further reduce a delay of reading stored data.

When the index information of the target data set is obtained, if the index information of the target data set is obtained preferentially from the first index information recorded in the primary index area, when the target data set fails to be obtained based on the first index information, the index information of the target data set may continue to be obtained from the second index information recorded in the online index area, to obtain the target data set based on the index information.

The target data set may be obtained according to a data read instruction. For example, in the storage field, the target data set is obtained according to a data read instruction.

Correspondingly, the data read instruction instructs to read a target data block in the target data set, and the method further includes: obtaining index information of the target data block; obtaining, based on the index information of the target data block, the target data block from the target data set with combine decompression; and feeding back the target data block according to the data read instruction.

In an implementation, the index information of the target data block indicates a logical index number of the target data block, and the obtaining, based on the index information of the target data block, the target data block from the target data set with combine decompression includes: obtaining, based on the logical index number, the target data block from the target data set with combine decompression.

According to a third aspect, this application provides a data processing apparatus. The apparatus includes: an obtaining module, configured to obtain a plurality of to-be-compressed data blocks; a combination module, configured to combine the plurality of to-be-compressed data blocks; and a compression module, configured to compress the plurality of combined to-be-compressed data blocks, to obtain a data set with combine compression.

Optionally, the plurality of to-be-compressed data blocks are sequentially sorted, and a coding partition of any one of the plurality of to-be-compressed data blocks includes the any one to-be-compressed data block and all to-be-compressed data blocks that are in the plurality of to-be-compressed data blocks and that are sorted before the any one to-be-compressed data block.

Optionally, the compression module is specifically configured to compress the plurality of combined to-be-compressed data blocks based on forward coding.

Optionally, the obtaining module is specifically configured to: obtain a plurality of to-be-written data blocks according to a data write instruction; and obtain the plurality of to-be-compressed data blocks based on the plurality of to-be-written data blocks.

Optionally, the compression module is further configured to store the data set in a storage medium.

Optionally, the compression module is further configured to update index information of the storage medium based on a location of the data set in the storage medium.

Optionally, the index information further indicates that the data set is obtained through combine compression.

Optionally, the obtaining module is specifically configured to: obtain a plurality of to-be-filtered data blocks; and obtain the plurality of to-be-compressed data blocks based on to-be-filtered data blocks including similar data in the plurality of to-be-filtered data blocks.

Optionally, the obtaining module is specifically configured to perform deduplication on the to-be-filtered data blocks including similar data, to obtain the plurality of to-be-compressed data blocks.

Optionally, index information of a reserved to-be-filtered data block with deduplication further indicates that the reserved to-be-filtered data block is obtained through deduplication.

Optionally, index information of the to-be-compressed data blocks further indicates logical index numbers of the plurality of to-be-compressed data blocks.

According to a fourth aspect, this application provides a data processing apparatus. The apparatus includes: a first obtaining module, configured to obtain index information of a to-be-decompressed target data set, where the target data set includes one or more data blocks, and the target data set is obtained through combine compression; a second obtaining module, configured to obtain the target data set based on the index information of the target data set; and a decompression module, configured to perform combine decompression on the target data set, to obtain a target data set with combine decompression.

Optionally, the decompression module is specifically configured to: when the index information of the target data set indicates that the target data set is obtained through combine compression, perform combine decompression on the target data set, to obtain the target data set with combine decompression.

Optionally, the target data set is stored in a storage medium, both a primary index area and an online index area of the storage medium record index information, the primary index area records first index information of all data stored in the storage medium, the online index area records second index information, the first index information is obtained by updating the second index information, and the first obtaining module is specifically configured to obtain the index information of the target data set preferentially from the first index information recorded in the primary index area.

Optionally, when the target data set fails to be obtained based on the first index information, the first obtaining module is further specifically configured to obtain the index information of the target data set from the second index information recorded in the online index area.

Optionally, the target data set is obtained according to a data read instruction.

Optionally, the data read instruction instructs to read a target data block in the target data set. The first obtaining module is further configured to obtain index information of the target data block; the second obtaining module is further configured to: obtain, based on the index information of the target data block, the target data block from the target data set with combine decompression; and the second obtaining module is further configured to feed back the target data block according to the data read instruction.

Optionally, the index information of the target data block indicates a logical index number of the target data block, and the second obtaining module is specifically configured to: obtain, based on the logical index number, the target data block from the target data set with combine decompression.

According to a fifth aspect, this application provides a computing device, including a memory and a processor. The memory stores program instructions, and the processor runs the program instructions to perform the method provided in any one of the first aspect, the second aspect, and the possible implementations of the first aspect and the second aspect of this application.

According to a sixth aspect, this application provides a computer cluster, including a plurality of computing devices. The plurality of computing devices include a plurality of processors and a plurality of memories, the plurality of memories store program instructions, and the plurality of processors run the program instructions, so that the computer cluster performs the method provided in any one of the first aspect, the second aspect, and the possible implementations of the first aspect and the second aspect of this application.

According to a seventh aspect, this application provides a computer-readable storage medium. The computer-readable storage medium is a non-volatile computer-readable storage medium, and the computer-readable storage medium includes program instructions. When the program instructions are run on a computing device, the computing device is enabled to perform the method provided in any one of the first aspect, the second aspect, and the possible implementations of the first aspect and the second aspect of this application.

According to an eighth aspect, this application provides a computer program product including instructions. When the computer program product runs on a computer, the computer is enabled to perform the method provided in any one of the first aspect, the second aspect, and the possible implementations of the first aspect and the second aspect of this application.

### BRIEF DESCRIPTION OF DRAWINGS

FIG. 1 is a diagram of an implementation environment related to a data processing method according to an embodiment of this application;
FIG. 2 is a diagram of an implementation environment related to another data processing method according to an embodiment of this application;
FIG. 3 is a diagram of an architecture of a storage system according to an embodiment of this application;
FIG. 4 is a flowchart of implementing data writing by using a data processing method according to an embodiment of this application;
FIG. 5 is a diagram of a coding partition of a data block according to an embodiment of this application;
FIG. 6 is a diagram of a structure of a storage system according to an embodiment of this application;
FIG. 7 is a diagram of a data write process according to an embodiment of this application;
FIG. 8 is a flowchart of implementing data reading by using a data processing method according to an embodiment of this application;
FIG. 9 is a diagram of a data read process according to an embodiment of this application;
FIG. 10 is a diagram of a data processing apparatus according to an embodiment of this application;
FIG. 11 is a diagram of another data processing apparatus according to an embodiment of this application;
FIG. 12 is a diagram of a structure of a computing device according to an embodiment of this application; and
FIG. 13 is a diagram of a structure of a computing device cluster according to an embodiment of this application.

### DESCRIPTION OF EMBODIMENTS

To make the objectives, technical solutions, and advantages of this application clearer, the following further describes implementations of this application in detail with reference to the accompanying drawings.

As the scale of storage (such as cloud storage) systems continuously expands and some new applications and services have higher performance requirements, the storage systems change significantly in two aspects. In one aspect, a storage capacity expands rapidly, and storage costs need to be reduced to improve core competitiveness of the storage systems. In the other aspect, the applications and the services that have higher performance requirements need to use storage devices with better performance, to meet the performance requirements of these applications and services. As a result, storage costs are multiplied. Both changes require an effective method to reduce the storage costs of the storage systems and improve the core competitiveness of the storage systems.

A data deduplication and compression technology is an effective and direct method to reduce the storage costs. There are two key technical links: data deduplication and data compression. Redundant data in a storage system can be reduced through data deduplication and data compression, to reduce data and greatly reduce storage costs of the entire storage system. In some scenarios, data that needs to be processed in a storage system includes a large amount of similar data, and the similar data is distributed very discretely and unevenly in time and space. In view of this feature, the data deduplication and compression technology can cluster the similar data distributed very discretely and unevenly in time and space by sampling feature values, and the data is compressed by using a hierarchical data reduction technology. The hierarchical data reduction technology is used to search for identical data in the clustered similar data for deduplication; and in addition, is used to compress data in the clustered similar data by using a delta compression solution, to obtain delta blocks, and compress the delta blocks by using a deep compression algorithm, to further improve a reduction ratio.

However, the data deduplication and compression technology has many disadvantages in overall solution design and has much room for improvement. For example, during compression, except that a reference block of delta compression needs to undergo only one compression procedure, each remaining data block needs to undergo two compression procedures. To be specific, delta compression needs to be performed first, and then deep compression is performed. As a result, a data compression procedure is complex and redundant. A decompression procedure is more complex. Except that a reference block of delta compression needs to undergo only one decompression procedure, each data block needs to undergo three decompression procedures, where a reference block is decompressed once, and a similar data block is decompressed twice. Due to redundant compression and decompression procedures, a compression and decompression delay is increased. As a result, system performance for a data compression and decompression system has much room for improvement.

An embodiment of this application provides a data processing method. In a data compression phase, after obtaining a plurality of to-be-compressed data blocks, a computing device combines the plurality of to-be-compressed data blocks, and then performs compression (also referred to as combine compression) on the plurality of combined to-be-compressed data blocks, to obtain a data set with combine compression. In a data decompression phase, after obtaining index information of the to-be-decompressed target data set, the computing device obtains the target data set based on the index information of the target data set, and then performs combine decompression on the target data set, to obtain a target data set with combine decompression. The target data set includes one or more data blocks, and the target data set is obtained through combine compression.

In this way, when data is compressed, combine compression on the data is applied, so that a data compression procedure is simplified, a data compression delay is effectively reduced, data compression efficiency is improved, and consumption of a resource (for example, a central processing unit (central processing unit, CPU)) for compression is reduced. Similarly, when data is decompressed, combine decompression on the data is applied, so that a data decompression delay is effectively reduced, data decompression efficiency is improved, and consumption of a resource for decompression is reduced.

The following first describes an implementation environment related to a data processing method provided in an embodiment of this application.

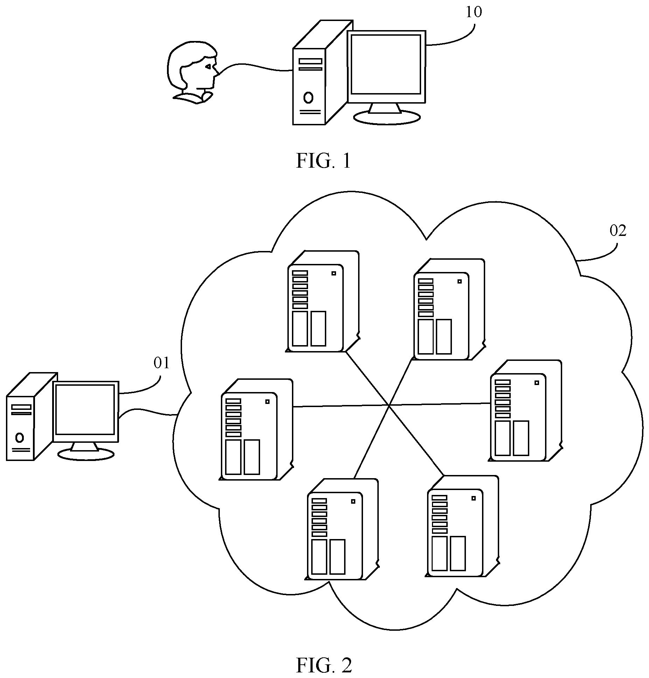

FIG. 1 is a diagram of an implementation environment related to a data processing method according to an embodiment of this application. As shown in FIG. 1, the implementation environment includes a computing device 10. The computing device 10 may obtain a plurality of to-be-compressed data blocks, and perform the data processing method provided in this embodiment of this application on the plurality of to-be-compressed data blocks, to compress the plurality of to-be-compressed data blocks. Alternatively, the computing device 10 may obtain a to-be-decompressed target data set, and perform the data processing method provided in this embodiment of this application on the target data set, to decompress the target data set.

In an implementation, the data processing method provided in this embodiment of this application may be implemented by running an executable program by the computing device 10. For example, the executable program in the data processing method may be presented in a form of an application installation package. After the application installation package is installed in the computing device 10, the data processing method can be implemented by running the executable program. In this case, the computing device 10 may be a terminal. The terminal may be a computer, a personal computer, a portable mobile terminal, a multimedia player, an e-book reader, a wearable device, or the like.

FIG. 2 is a diagram of an implementation environment related to another data processing method according to an embodiment of this application. As shown in FIG. 2, the implementation environment may include a client 01 and a storage system 02. The storage system 02 is configured to store data, and perform the data processing method provided in this embodiment of this application. The client 01 can establish a communication connection with the storage system 02. For example, a communication connection may be established between the client 01 and the storage system 02 by using a network. Optionally, the network may be a local area network, the Internet, or another network. This is not limited in this embodiment of this application.

The client 01 is used by a user to interact with the storage system 02. In an implementation, the client 01 is configured to send an instruction to the storage system 02 according to an indication of the user. For example, the client 01 is configured to send a data write instruction to the storage system 02 according to an indication of the user, to instruct to write data into the storage system. For another example, the client 01 is configured to send a data read instruction to the storage system 02 according to an indication of the user, to instruct to read data from the storage system.

In a possible implementation, the client 01 may be a desktop computer, a laptop computer, a mobile phone, a smartphone, a tablet computer, a multimedia player, a smart home appliance, an artificial intelligence device, a smart wearable device, an e-reader, a smart vehicle-mounted device, an internet of things device, or the like.

The storage system 02 is configured to receive the instruction sent by the client 01, and perform an operation indicated by the instruction. In an implementation, before storing data, the storage system 02 provided in this embodiment of this application needs to compress the data first, and then store the compressed data in a storage medium. Correspondingly, before reading data, the storage system 02 needs to first obtain a target data set from the storage medium, decompress the target data set, obtain a to-be-read data block from the decompressed target data set, and then return the data block. For example, the storage system 02 is configured to: receive a data write instruction, combine a plurality of to-be-written to-be-compressed data blocks according to the data write instruction according to the data processing method provided in this embodiment of this application, perform combine compression on the plurality of combined to-be-compressed data blocks to obtain a data set with combine compression, and then store the data set with combine compression in the storage medium. For another example, the storage system 02 is configured to: receive a data read instruction, obtain index information of a to-be-decompressed target data set according to the data read instruction according to the data processing method provided in this embodiment of this application, obtain the target data set based on the index information, perform combine decompression on the target data set to obtain a target data set with combine decompression, then obtain a target data block from the target data set with combine decompression, and feed back the target data block according to the data read instruction. The target data set includes one or more data blocks, and the target data set is obtained through combine compression.

In a possible implementation, the storage system 02 may be implemented by a computing device. In addition, the computing device may be a server (for example, a cloud server). Usually, the storage system 02 may be implemented by a server cluster including several servers, or by a cloud computing service center. A large quantity of basic resources owned by a cloud service provider are deployed in the cloud computing service center. For example, a computing resource, a storage resource, and a network resource are deployed in the cloud computing service center. The cloud computing service center may implement, by using the large quantity of basic resources, the data processing method provided in this embodiment of this application.

When the storage system 02 is implemented by the cloud computing service center, the user can access a cloud platform through the client 01 and use, through the cloud platform, a storage service provided by the storage system. In this case, a function implemented by using the data processing method provided in this embodiment of this application may be abstracted by the cloud service provider into a storage cloud service on the cloud platform, and the cloud platform can provide the storage cloud service for the user by using a resource in the cloud computing center. After the user purchases the storage cloud service on the cloud platform, the storage cloud service can be used to store, for the user, data that needs to be written, or provide stored data for the user. Optionally, the cloud platform may be a cloud platform of a center cloud or a cloud platform of an edge cloud, or include cloud platforms of a center cloud and an edge cloud. This is not specifically limited in this embodiment of this application.

It should be noted that, in the implementation environment shown in FIG. 2, the storage system 02 may alternatively be implemented by using another resource platform other than the cloud platform. This is not specifically limited in this embodiment of this application. In this case, the storage system 02 may be implemented by using a resource in the another resource platform, and provide a related storage service for the user.

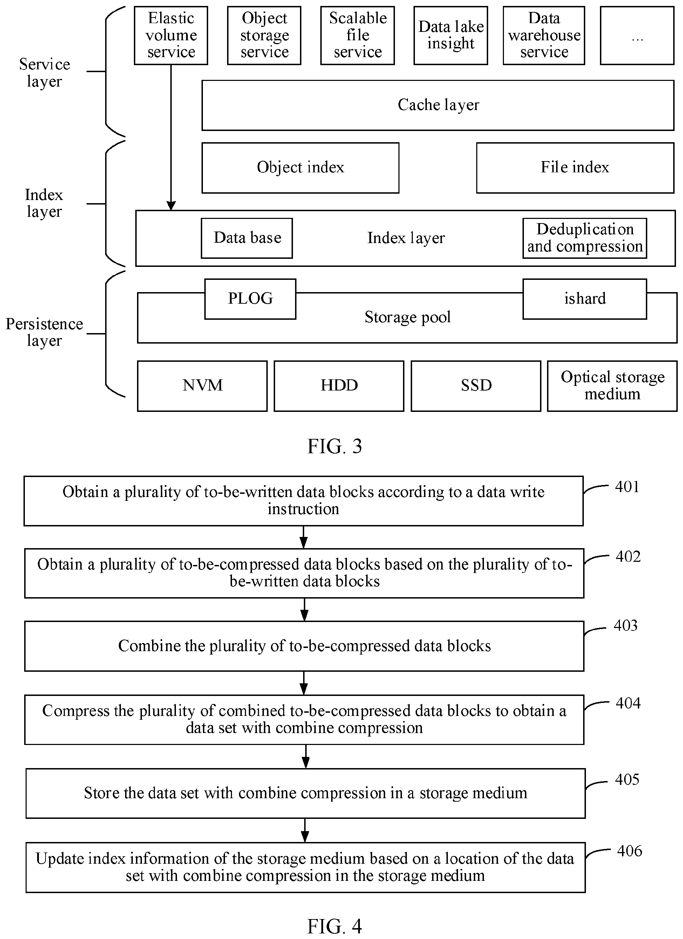

In an implementation, FIG. 3 is a diagram of an architecture of a storage system according to an embodiment of this application. Optionally, the storage system may be a distributed storage system. As shown in FIG. 3, the storage system includes: a service layer (service layer), an index layer (index layer), and a persistence layer (persistence layer).

The service layer is used to provide unified interface protocol services for users. The service layer provides the following services: an elastic volume service (elastic volume service, EVS), an object storage service (object storage service, OBS), a scalable file service (scalable file service, SFS), a data lake insight (data lake insight, DLI) service, and a data warehouse service (data warehouse service, DWS). In addition, to ensure service performance, the service layer is further configured with a cache layer (cache layer).

The index layer is used to provide a metadata management service for the distributed storage system. The index layer can run a data base (data base, DB), perform deduplication and compression, and interact with the service layer through object index and file index. The data base may be a key-value data base (key-value data base, KVDB).

The persistence layer is used to provide a persistent storage service for the distributed system. The persistence layer can be write-optimized (write-optimized) and read-optimized (read-optimized) by using an ishard mode and a PLOG mode. The ishard mode and the PLOG mode can share a storage pool. The storage pool may be a data function virtualization (data function virtualization, DFV) storage pool. In addition, a storage medium of the storage pool may be a non-volatile memory (non-volatile memory, NVM), a solid-state drive (solid-state drive, SSD), a hard disk drive (hard disk drive, HDD), an optical storage medium, or the like.

It should be understood that the foregoing content is an example of an application scenario of the data processing method provided in embodiments of this application, and does not constitute a limitation on the application scenario of the data processing method. A person of ordinary skill in the art may learn that, as a service requirement changes, the application scenario of the data processing method may be adjusted based on the application requirement. For example, the data processing method provided in embodiments of this application may be further applied to the network transmission field. Similar data may be clustered in to-be-compressed data, and then combine compression is performed on the clustered similar data, to reduce a network transmission data amount and improve a network transmission rate. In addition, the data processing method provided in embodiments of this application may be further applied to a plurality of compression fields, such as an image compression field, a video compression field, and a dedicated data base compression field, so that a data compression and decompression delay is reduced, data compression and decompression efficiency is improved, and consumption of a resource for compression and decompression is reduced by using a combine compression function and a combine decompression function provided in embodiments of this application.

An example in which the data processing method provided in embodiments of this application is applied to the application scenario shown in FIG. 2 is used below to describe an implementation process of the data processing method provided in embodiments of this application. A data access process of a storage system includes a data write process and a data read process. The following first describes the data write process, and then describes the data read process. As shown in FIG. 4, the data write process may include the following steps.

Step 401: Obtain a plurality of to-be-written data blocks according to a data write instruction.

When a user needs to write data into the storage system, the user can send the data write instruction to the storage system through a client. The data write instruction carries data to be written into the storage system, or the data write instruction may indicate the data to be written into the storage system. Therefore, the storage system may obtain the to-be-written data according to the data write instruction. The to-be-written data blocks may be obtained by dividing, by the storage system, the data to be written as indicated by the user. For example, the storage system may divide, based on a fixed length or a non-fixed length, the data to be written into the storage system, to obtain the plurality of to-be-written data blocks. Before storing the to-be-written data, the storage system may perform deduplication and compression on the data. In addition, the storage system usually processes a plurality of to-be-written data blocks in one deduplication and compression process. The plurality of to-be-written data blocks that are compressed in one deduplication and compression process may be considered as data blocks in a same data set. The storage system may have a plurality of data sets on which deduplication and compression needs to be performed, each data set includes a plurality of to-be-written data blocks, and a plurality of data blocks in a same data set may be data blocks including similar data. In addition, the plurality of to-be-written data blocks in the same data set may be from a same user, or may be from different users. This is not specifically limited in embodiments of this application.

Step 402: Obtain a plurality of to-be-compressed data blocks based on the plurality of to-be-written data blocks.

In an implementation, the plurality of to-be-compressed data blocks may be data blocks including similar data. Obtaining the plurality of to-be-compressed data blocks based on the plurality of to-be-written data blocks includes: obtaining a plurality of to-be-filtered data blocks based on the plurality of to-be-written data blocks; and obtaining the plurality of to-be-compressed data blocks based on to-be-filtered data blocks including similar data in the plurality of to-be-filtered data blocks.

In a storage scenario, to-be-written data may include data that needs to be compressed and data that does not need to be compressed. The obtaining a plurality of to-be-filtered data blocks based on the plurality of to-be-written data blocks includes: filtering the plurality of to-be-written data blocks for data blocks that need to be compressed, to obtain the plurality of to-be-filtered data blocks.

Optionally, the obtaining the plurality of to-be-compressed data blocks based on to-be-filtered data blocks including similar data in the plurality of to-be-filtered data blocks may include: after filtering the to-be-filtered data blocks including the similar data from the plurality of to-be-filtered data blocks, performing deduplication on the to-be-filtered data blocks including the similar data, to obtain the plurality of to-be-compressed data blocks. The performing deduplication on the to-be-filtered data blocks including the similar data refers to: retrieving, from the plurality of to-be-filtered data blocks including the similar data, a plurality of identical to-be-filtered data blocks, reserving one to-be-filtered data block in the plurality of identical to-be-filtered data blocks, and deleting a remaining to-be-filtered data block in the plurality of identical to-be-filtered data blocks. When fingerprints of a plurality of to-be-filtered data blocks are the same, it may be determined that the plurality of to-be-filtered data blocks are identical data blocks. A fingerprint of a data block may be a hash value over all bytes of the data block. The fingerprint of the data block may be obtained according to a strong hash algorithm. In addition, because each data block processed by the storage system is prestored in a data base of the storage system, the to-be-written data block, the to-be-filtered data block, and the to-be-compressed data block are prestored in the data base, and index information of the data block is recorded in the storage system. After the remaining to-be-filtered data block in the plurality of identical to-be-filtered data blocks is deleted, a storage address of the reserved data block in the plurality of identical to-be-filtered data blocks may be used to update index information of the remaining to-be-filtered data block in the plurality of identical to-be-filtered data blocks. For example, when the storage system uses a key-value (key-value) pair to record index information of a data block, a physical address (physical address, PA) of the reserved data block in the plurality of identical to-be-filtered data blocks may be used to update a physical address recorded in a value of a key-value pair of the remaining to-be-filtered data block in the plurality of identical to-be-filtered data blocks.

The to-be-filtered data blocks including similar data in the plurality of to-be-filtered data blocks may be obtained by clustering the plurality of to-be-filtered data blocks. For example, the plurality of to-be-filtered data blocks may be clustered based on feature values of the plurality of to-be-filtered data blocks, data blocks with a same feature value are clustered into one type, and a plurality of data blocks in each type obtained through clustering are to-be-filtered data blocks including similar data. Optionally, a feature value of a data block may be obtained by assembling hash values of a plurality of groups of segments of the data block in a specific manner.

Step 403: Combine the plurality of to-be-compressed data blocks.

Combining the plurality of to-be-compressed data blocks includes: packing the plurality of to-be-compressed data blocks into one data package. In an implementation, when the storage system is implemented by using a plurality of computing devices deployed in a distributed manner, and obtaining the to-be-compressed data blocks and performing compression are respectively performed by different computing devices, after obtaining a plurality of to-be-compressed data blocks including similar data, a computing device configured to obtain the to-be-compressed data blocks may pack the plurality of to-be-compressed data blocks into one data package, and provide the data package for a computing device configured to perform compression. Therefore, the computing device configured to perform compression directly uses the data package as an input of a compression algorithm, to perform combine compression (Combine compression, CC) on the plurality of to-be-compressed data blocks.

Step 404: Compress the plurality of combined to-be-compressed data blocks to obtain a data set with combine compression.

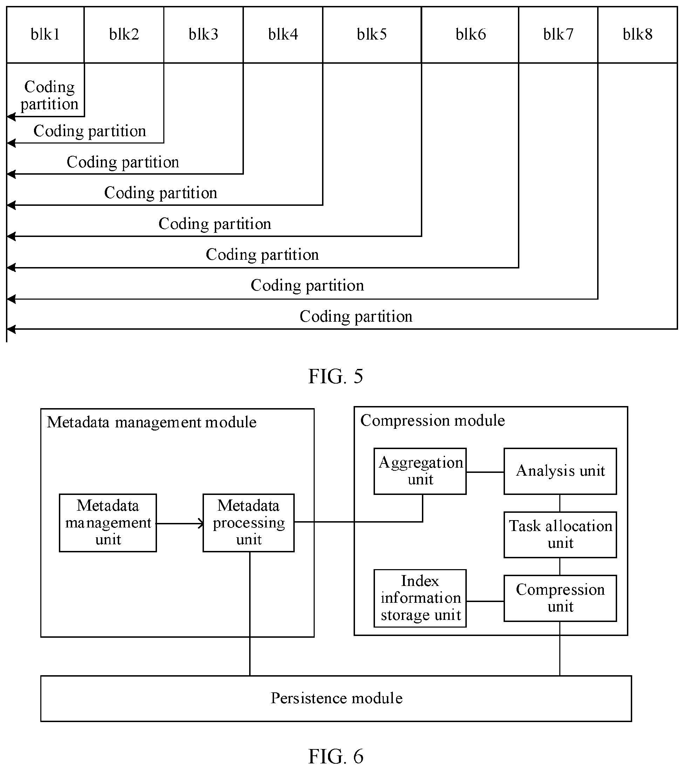

After the plurality of combined to-be-compressed data blocks are obtained, compression may be performed on the plurality of to-be-compressed data blocks, to obtain the data set with combine compression. The compression may be performing deep compression on the plurality of to-be-compressed data blocks. In an implementation, because the plurality of to-be-compressed data blocks are usually sequentially sorted, when compression is performed on any one of the plurality of to-be-compressed data blocks, a coding partition of the any one to-be-compressed data block may include the any one to-be-compressed data block and all to-be-compressed data blocks that are in the plurality of to-be-compressed data blocks and that are sorted before the any one to-be-compressed data block. The coding partition indicates a range of sample data used for searching for redundant data of a current data block. For example, as shown in FIG. 5, the plurality of data blocks are a data block blk1 to a data block blk8, and a coding partition of a data block blk4 includes the data block blk1, a data block blk2, a data block blk3, and the data block blk4. In this case, performing compression on the data block blk4 includes: searching for redundant data of the data block blk4 in the data block blk1, the data block blk2, the data block blk3, and the data block blk4, and then performing deep compression on the data block blk4 based on the redundant data.

Generally, a larger coding partition of a data block indicates a larger data amount of a sample that can be used for searching for redundant data in the data block. Therefore, for a same data block, a larger coding partition of the data block indicates a larger reduction ratio of the data block. In embodiments of this application, because a data amount of a coding partition searched for redundant data during compression of a single data block is increased, utilization that is in time and space and that is of a sample for searching for redundant data of a to-be-compressed data block is improved, and a reduction ratio of compression is further improved, thereby further reducing storage costs.

In an implementation, combine compression may be performed on the plurality of combined to-be-compressed data blocks based on forward coding. In this way, a compression sequence of a compression algorithm can perfectly match a coding partition of each data block, which is more conducive to further improving a reduction ratio while maintaining low compression/decompression overheads. In addition, when a compression algorithm is selected, reference may be made to a compression ratio of the compression algorithm, to further ensure a compression ratio of compressed data, thereby ensuring storage costs of the storage system.

Step 405: Store the data set with combine compression in a storage medium.

After performing combine compression on the data set, the storage system may store the data set with combine compression to a disk, to make the data set persistent. In an implementation, after the data set with combine compression is obtained, metadata information of the data set may be added to a data header of the data set, and then the data set to which the metadata information is added is stored in the storage medium.

Step 406: Update index information of the storage medium based on a location of the data set with combine compression in the storage medium.

After a location of each data block in the data set with combine compression in the storage medium is obtained, the index information of the storage medium may be further updated based on the location, so that when data in the data set needs to be read, a corresponding data block can be located based on an index in the index information. The index information of the storage medium is used to record index information of all data stored in the storage system.

In an implementation, index information of the to-be-compressed data blocks may not only indicate a physical address of compressed data, but also indicate logical index numbers (logic-index) of compressed data blocks. The logical index numbers may be allocated to a plurality of to-be-compressed data blocks before compression is performed on the plurality of to-be-compressed data blocks. For example, after deduplication is performed on the plurality of to-be-filtered data blocks, a logical index number may be allocated to a remaining to-be-filtered data block with deduplication. For another example, when the storage system records, by using a key-value pair, index information of the data set with combine compression, for any to-be-compressed data block in the data set, a part of a fingerprint of the any to-be-compressed data block may be extracted, a key of index information of the any to-be-compressed data block may be obtained based on the extracted fingerprint of the any to-be-compressed data block, and a value of the index information of the any to-be-compressed data block may be obtained based on a physical address and a logical index number of the any to-be-compressed data block.

Optionally, the index information further indicates that the data set is obtained through combine compression. Combine compression may be or may not be performed on the data stored in the storage system. The index information indicates that the data is obtained through combine compression, so that data with combine compression can be distinguished from data without combine compression.

Similarly, index information of a reserved to-be-filtered data block with deduplication may further indicate that the reserved to-be-filtered data block is obtained through deduplication. In this way, data with deduplication can be distinguished from data without deduplication in the storage system.

In an implementation, because the index information of the storage medium is used to record the index information of all the data stored in the storage system, when the storage system is implemented by using a plurality of computing devices that are deployed in a distributed manner, and a computing device that uses the storage medium is different from a computing device that performs compression, after performing combine compression on the data, the computing device that performs compression may store a data set with combine compression in the storage medium, and record, in the computing device, index information of the data set with combine compression. In this case, step 406 may include: updating the index information of the storage medium based on the index information that is of the data set with combine compression and that is recorded by the computing device that performs compression.

For example, FIG. 6 is a diagram of a structure of a storage system according to an embodiment of this application. As shown in FIG. 6, the storage system is a distributed storage system. The storage system may include a metadata management module, a compression module, and a persistence module. The metadata management module, the compression module, and the persistence module are implemented by using different computing devices. The metadata management module is configured to receive an input/output (input/output, I/O) request of a user, and perform a metadata management process based on the I/O request. The compression module is configured to perform combine compression and/or combine decompression on data. The persistence module is configured to store received data, to implement data persistence. The metadata management module includes a metadata management unit (for example, LunMap) and a metadata processing unit (for example, DusClient). The metadata management unit is configured to record metadata of all data stored in a storage medium of the storage system, and the metadata includes index information of the storage medium. The metadata processing unit is configured to interconnect with the metadata management unit, the compression module, and the persistence module, and is responsible for calculating a fingerprint and a feature value of each data block, storing the obtained fingerprint and feature value to the persistence module, and combining the obtained fingerprint and feature value with other metadata information of the data block and sending the combined information to the compression module. The compression module includes an aggregation unit (for example, OpTable), an analysis unit (for example, a post data analysis (post data analysis, PDA) unit), a task allocation unit (for example, task mag), a compression unit (for example, a post data reduce (post data reduce, PDR) unit), and an index information storage unit (for example, FPTable).

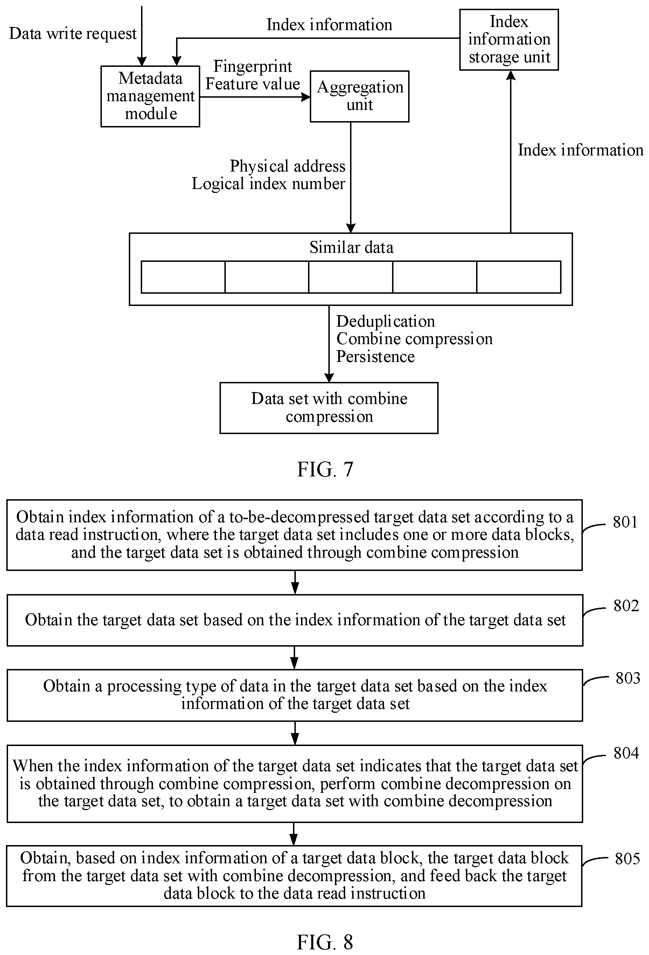

As shown in FIG. 6 and FIG. 7, in a process of writing data into the storage system, the aggregation unit is configured to receive the fingerprint, the feature value, and the like sent by the metadata processing unit in the metadata management module, and is responsible for aggregating data with a same feature value based on the feature value to obtain aggregated similar data, providing the aggregated similar data for the compression unit, and providing a physical address and a logical index number of the similar data for the compression unit. The analysis unit is configured to periodically analyze the aggregated similar data provided by the aggregation unit, and assemble similar data scattered in the entire storage system into a similar data link. The task allocation unit is configured to receive the similar data link sent by the analysis unit, form different compression tasks according to a characteristic that feature values are scattered in the storage system, and allocate the compression tasks to the compression unit. The compression unit is configured to perform deduplication and combine compression based on the allocated compression tasks, make a data set with combine compression persistent to the persistence module, generate index information of each data block in the data set with combine compression, and provide the index information for the index information storage unit. Optionally, before performing combine compression on the data, the compression unit may further first find, through fingerprint comparison, identical data on the similar data link, reserve only one of a plurality of copies of identical data, and then perform combine compression on remaining data. The index information storage unit is configured to receive the index information that is of each data block in the data set and that is sent by the compression unit, make the index information persistent, and update, based on the index information, the index information recorded in the metadata management unit.

In conclusion, in the data processing method provided in embodiments of this application, in a data compression phase, after obtaining the plurality of to-be-compressed data blocks, the computing device combines the plurality of to-be-compressed data blocks, and then performs combine compression on the plurality of combined to-be-compressed data blocks, to obtain the data set with combine compression. In this way, when data is compressed, combine compression on the data is applied, so that a data compression procedure is simplified, a data compression delay is effectively reduced, data compression efficiency is improved, and consumption of a resource (for example, a CPU) for compression is reduced. For example, for a set including N similar data blocks, when compression is performed by using a current similarity-based deduplication and compression solution, 2N-1 compression cycles (including a delta compression process and a deep compression process) need to be performed. However, according to the data processing method provided in embodiments of this application, a compression process may be simplified to one time of compression. Therefore, the data compression procedure is effectively simplified.

The following describes a data read process. As shown in FIG. 8, the data read process may include the following steps.

Step 801: Obtain index information of a to-be-decompressed target data set according to a data read instruction, where the target data set includes one or more data blocks, and the target data set is obtained through combine compression.

After data is stored in a storage system, if a user needs to read the data from the storage system, the user may send a data read instruction to the storage system through a client. The data read instruction carries indication information of a to-be-read target data block. The storage system may obtain, based on the indication information, the target data block and the index information of the target data set in which the target data block is located. The index information of the target data block indicates a storage location of the target data block. The index information of the target data set indicates a storage location of the target data set.

Both a primary index area and an online index area of a storage medium record index information, the primary index area records first index information of all data stored in the storage medium, the online index area records second index information, and the first index information is obtained by updating the second index information. For example, as shown in FIG. 6, the primary index area may be maintained by the metadata management unit, and the online index area may be maintained by the index information storage unit. Obtaining the index information of the to-be-decompressed target data set according to the data read instruction may include: obtaining the index information of the target data set preferentially from the first index information recorded in the primary index area. The primary index area records the first index information of all the data stored in the storage medium, and the online index area records the second index information. The second index information may indicate only a part of data stored in the storage medium. When the index information of the target data set is obtained preferentially from the first index information recorded in the primary index area, it can be ensured that the index information of the target data set is obtained. In addition, as shown in FIG. 6, if the metadata management module, the compression module, and the persistence module are implemented by using different computing devices, because the metadata management module is configured to receive the data read instruction, and the index information of the target data set is obtained preferentially from the first index information recorded in the primary index area, the index information does not need to be obtained by accessing the compression module via the metadata management module. This can reduce one map operation, reduce network overheads for searching for the index information, and further reduce a delay of reading stored data.

Step 802: Obtain the target data set based on the index information of the target data set.

After the index information of the target data set is obtained, a storage location of the target data set in the storage medium may be first obtained based on the index information, and then the target data set is read from the storage location. In an implementation, the index information may indicate a logical number (plogId) of the storage address of the target data set in a disk and an offset (offset) of the target data set on a storage unit indicated by the logical number. The storage location of the target data set on the storage medium may be determined based on the logical number and the offset, and then the target data set is read from the storage location.

It should be noted that, when the index information of the target data set is obtained, if the index information of the target data set is obtained preferentially from the first index information recorded in the primary index area, when the target data set fails to be obtained based on the first index information, the index information of the target data set may continue to be obtained from the second index information recorded in the online index area, to obtain the target data set based on the index information. In this case, failing to obtain the target data set based on the first index information may result from that latest index information of the target data set is not yet updated from the online index area to the primary index area. For example, when data in the target data set is a data block with deduplication, this case may occur because a reference block of the deduplicated data block changes. As a result, a physical address of data corresponding to the deduplicated data block changes, but a new physical address is not updated to the primary index area in time. For another example, when data in the target data set is a data block with combine compression, this case may occur because the combined data block participates in new combine compression. Because the storage system uses logic of appended writing to write the combined data block into the disk to make the data block persistent, physical addresses of all data change, but new physical addresses are not updated to the primary index area in time.

Step 803: Obtain a processing type of the data in the target data set based on the index information of the target data set.

After the target data set is obtained, the processing type of the data in the target data set may be obtained based on the index information of the target data set, and then an implementation of obtaining the target data block from the target data set is determined based on the processing type. In addition, when the processing type of the data in the target data set is combine compression, step 804 is performed to perform combine decompression on the target data set, to obtain the target data block in the target data set. It should be noted that, when the processing type of the data in the target data set is incomplete deduplication and/or non-combine compression, the target data block may be directly obtained from the target data set based on the index information of the target data block.

It can be learned from the foregoing descriptions that, the index information may indicate that the data set is obtained through combine compression, and whether the data in the target data set is obtained through combine compression may be determined based on the index information. In an implementation, different values assigned to a field that indicates whether combine compression is performed on the data and that is in the index information indicate whether the data is obtained through combine compression. In this case, whether the data in the target data set is obtained through combine compression may be determined based on the values assigned to the field that indicates whether combine compression is performed on the data and that is in the index information.

Similarly, index information of a reserved to-be-filtered data block with deduplication may further indicate that the reserved to-be-filtered data block is obtained through deduplication. In this case, whether the data in the target data set is obtained through deduplication may be determined based on the index information. In an implementation, different values assigned to a field that indicates whether deduplication is performed on the data and that is in the index information indicate whether the data is obtained through deduplication. In this case, whether the data in the target data set is obtained through deduplication may be determined based on the values assigned to the field that indicates whether deduplication is performed on the data and that is in the index information.

Step 804: When the index information of the target data set indicates that the target data set is obtained through combine compression, perform combine decompression on the target data set, to obtain a target data set with combine decompression.

When the index information of the target data set indicates that the target data set is obtained through combine compression, combine decompression may be performed on the target data set, to obtain the target data set with combine decompression. In an implementation, a decompression method matching combine compression of the target data set may be used to perform combine decompression on the target data set. For example, when the target data set is obtained through combine compression based on forward coding, combine decompression may be performed on the target data set by using a decompression method matching the forward coding. In addition, when compression is performed on any one of a plurality of to-be-compressed data blocks that are sequentially sorted, if a coding partition of the any one to-be-compressed data block includes the any one to-be-compressed data block and all to-be-compressed data blocks that are in the plurality of to-be-compressed data blocks and that are sorted before the any to-be-compressed data block, decompression of the target data set can be completed by performing decompression only once during combine decompression.

Step 805: Obtain, based on the index information of the target data block, the target data block from the target data set with combine decompression, and feed back the target data block according to the data read instruction.

After the index information of the target data block is obtained, the target data block may be obtained from the target data set based on the index information, and then the target data block is fed back according to the data read instruction. In an implementation, the index information of the target data block indicates a logical index number of the target data block, and obtaining, based on the index information of the target data block, the target data block from the target data set with combine decompression includes: obtaining, based on the logical index number, the target data block from the target data set with combine decompression.

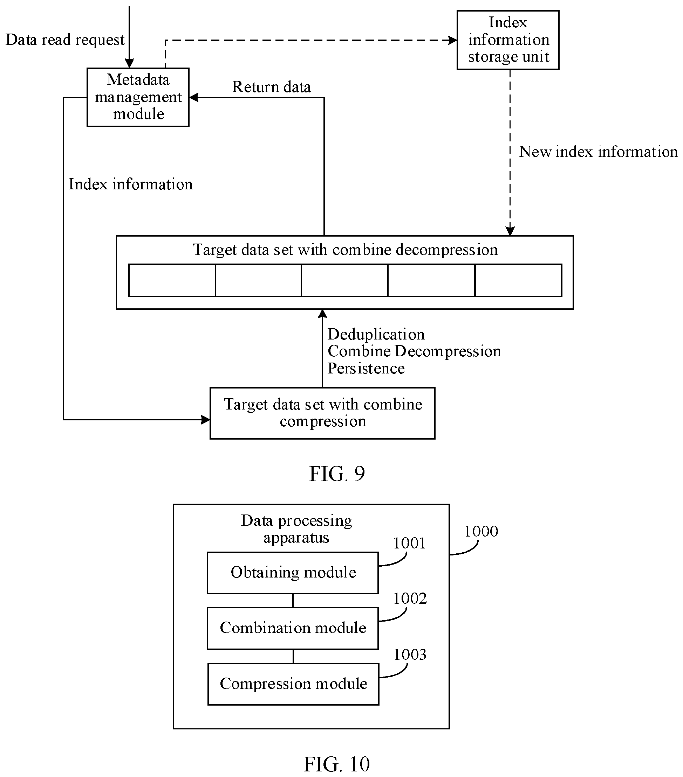

As shown in FIG. 6 and FIG. 9, in a process of reading the data from the storage system, after receiving a data read request, the metadata management module may obtain, from the metadata management unit, a target data block indicated by the data read request and index information of a target data set in which the target data block is located, and provide the index information for the compression module. The compression module may obtain the target data set from the storage medium based on the index information, perform combine decompression on the target data set, obtain the target data block from the target data set with combine decompression, and feed back the target data block to the metadata management module, to complete a process of reading the target data block. However, when the target data set fails to be obtained based on the index information obtained from the metadata management unit, as shown in FIG. 9, the metadata management module may obtain, from the index information storage unit, the target data block and new index information of the target data set in which the target data block is located, and then obtain the target data block based on the new index information.

In conclusion, in the data processing method provided in embodiments of this application, in a data decompression phase, after obtaining the index information of the to-be-decompressed target data set, the computing device obtains the target data set based on the index information of the target data set, and then performs combine decompression on the target data set, to obtain the target data set with combine decompression. The target data set includes one or more data blocks, and the target data set is obtained through combine compression. In this way, when data is decompressed, combine decompression on the data is applied, so that a data decompression delay is effectively reduced, data decompression efficiency is improved, and consumption of a resource for decompression is reduced. For example, for a data set with combine compression that includes a set of N similar data blocks, when the data set with combine compression is decompressed by using a current similarity-based deduplication and decompression solution, 3N-2 decompression cycles (including a deep decompression process of a reference block, a deep decompression process of similar data blocks, and a delta decompression process of similar data) need to be performed. However, according to the data processing method provided in embodiments of this application, a decompression process may be simplified to one time of decompression. Therefore, the data decompression procedure is effectively simplified.

It should be noted that a sequence of steps in the data processing method provided in embodiments of this application may be appropriately adjusted, and a step may be correspondingly added or deleted based on a situation. Any method variation readily figured out by a person skilled in the art within the technical scope disclosed in this application shall fall within the protection scope of this application. Therefore, details are not described again.

The foregoing describes the data processing method in embodiments of this application. In correspondence to the foregoing method, an embodiment of this application further provides a data processing apparatus. FIG. 10 is a diagram of a structure of a data processing apparatus according to an embodiment of this application. Based on the following plurality of modules shown in FIG. 10, the data processing apparatus shown in FIG. 10 can perform all or some of the operations shown in FIG. 4. It should be understood that the apparatus may include more additional modules than the shown modules, or some of the shown modules are omitted. This is not limited in this embodiment of this application. Optionally, the data processing apparatus may be configured on a cloud platform. As shown in FIG. 10, the data processing apparatus 1000 includes:
an obtaining module 1001, configured to obtain a plurality of to-be-compressed data blocks;
a combination module 1002, configured to combine the plurality of to-be-compressed data blocks; and
a compression module 1003, configured to compress the plurality of combined to-be-compressed data blocks, to obtain a data set with combine compression.

Optionally, the plurality of to-be-compressed data blocks are sequentially sorted, and a coding partition of any one of the plurality of to-be-compressed data blocks includes the any one to-be-compressed data block and all to-be-compressed data blocks that are in the plurality of to-be-compressed data blocks and that are sorted before the any one to-be-compressed data block.

Optionally, the compression module 1003 is specifically configured to compress the plurality of combined to-be-compressed data blocks based on forward coding.

Optionally, the obtaining module 1001 is specifically configured to: obtain a plurality of to-be-written data blocks according to a data write instruction; and obtain the plurality of to-be-compressed data blocks based on the plurality of to-be-written data blocks.

Optionally, the compression module 1003 is further configured to store the data set in a storage medium.

Optionally, the compression module 1003 is further configured to update index information of the storage medium based on a location of the data set in the storage medium.

Optionally, the index information further indicates that the data set is obtained through combine compression.

Optionally, the obtaining module 1001 is specifically configured to: obtain a plurality of to-be-filtered data blocks; and obtain the plurality of to-be-compressed data blocks based on to-be-filtered data blocks including similar data in the plurality of to-be-filtered data blocks.

Optionally, the obtaining module 1001 is specifically configured to perform deduplication on the to-be-filtered data blocks including similar data, to obtain the plurality of to-be-compressed data blocks.

Optionally, index information of a reserved to-be-filtered data block with deduplication further indicates that the reserved to-be-filtered data block is obtained through deduplication.

Optionally, index information of the to-be-compressed data blocks further indicates logical index numbers of the plurality of to-be-compressed data blocks.

In conclusion, in the data processing apparatus provided in this embodiment of this application, in a data compression phase, after obtaining a plurality of to-be-compressed data blocks, a computing device combines the plurality of to-be-compressed data blocks, and then performs combine compression on the plurality of combined to-be-compressed data blocks, to obtain a data set with combine compression. In this way, when data is compressed, combine compression on the data is applied, so that a data compression procedure is simplified, a data compression delay is effectively reduced, data compression efficiency is improved, and consumption of a resource (for example, a CPU) for compression is reduced. For example, for a set including N similar data blocks, when compression is performed by using a current similarity-based deduplication and compression solution, 2N-1 compression cycles (including a delta compression process and a deep compression process) need to be performed. However, according to the data processing apparatus provided in this embodiment of this application, a compression process may be simplified to one time of compression. Therefore, the data compression procedure is effectively simplified.

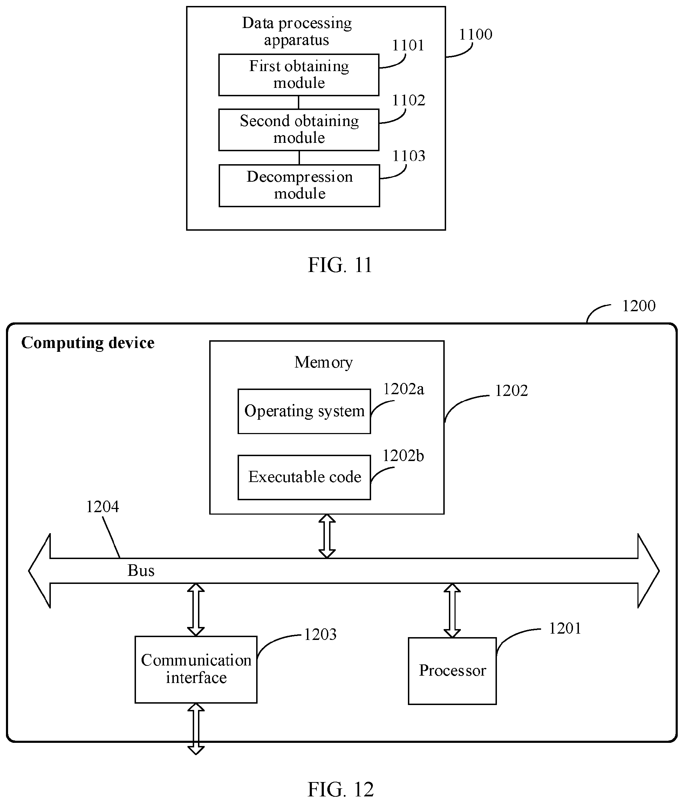

An embodiment of this application further provides another data processing apparatus. FIG. 11 is a diagram of a structure of a data processing apparatus according to an embodiment of this application. Based on the following plurality of modules shown in FIG. 11, the data processing apparatus shown in FIG. 11 can perform all or some of the operations shown in FIG. 8. It should be understood that the apparatus may include more additional modules than the shown modules, or some of the shown modules are omitted. This is not limited in this embodiment of this application. Optionally, the data processing apparatus may be configured on a cloud platform. As shown in FIG. 11, the data processing apparatus 1100 includes:
a first obtaining module 1101, configured to obtain index information of a to-be-decompressed target data set, where the target data set includes one or more data blocks, and the target data set is obtained through combine compression;
a second obtaining module 1102, configured to obtain the target data set based on the index information of the target data set; and
a decompression module 1103, configured to perform combine decompression on the target data set, to obtain a target data set with combine decompression.

Optionally, the decompression module 1103 is specifically configured to: when the index information of the target data set indicates that the target data set is obtained through combine compression, perform combine decompression on the target data set, to obtain the target data set with combine decompression.

Optionally, both a primary index area and an online index area of a storage medium record index information, the primary index area records first index information of all data stored in the storage medium, the online index area records second index information, the first index information is obtained by updating the second index information, and the first obtaining module 1101 is specifically configured to obtain the index information of the target data set preferentially from the first index information recorded in the primary index area.

Optionally, when the target data set fails to be obtained based on the first index information, the first obtaining module 1101 is further specifically configured to obtain the index information of the target data set from the second index information recorded in the online index area.

Optionally, the target data set is obtained according to a data read instruction.

Optionally, the data read instruction instructs to read a target data block in the target data set. The first obtaining module 1101 is further configured to obtain index information of the target data block; the second obtaining module 1102 is further configured to: obtain, based on the index information of the target data block, the target data block from the target data set with combine decompression; and the second obtaining module 1102 is further configured to feed back the target data block according to the data read instruction.

Optionally, the index information of the target data block indicates a logical index number of the target data block, and the second obtaining module 1102 is specifically configured to: obtain, based on the logical index number, the target data block from the target data set with combine decompression.

In conclusion, in the data processing apparatus provided in this embodiment of this application, in a data decompression phase, after obtaining index information of a to-be-decompressed target data set, a computing device obtains the target data set based on the index information of the target data set, and then performs combine decompression on the target data set, to obtain a target data set with combine decompression. The target data set includes one or more data blocks, and the target data set is obtained through combine compression. In this way, when data is decompressed, combine decompression on the data is applied, so that a data decompression delay is effectively reduced, data decompression efficiency is improved, and consumption of a resource for decompression is reduced. For example, for a data set with combine compression that includes a set of N similar data blocks, when the data set with combine compression is decompressed by using a current similarity-based deduplication and decompression solution, 3N-2 decompression cycles (including a deep decompression process of a reference block, a deep decompression process of similar data blocks, and a delta decompression process of similar data) need to be performed. However, according to the data processing apparatus provided in this embodiment of this application, a decompression process may be simplified to one time of decompression. Therefore, the data decompression procedure is effectively simplified.

The obtaining module 1001, the combination module 1002, the compression module 1003, the first obtaining module 1101, the second obtaining module 1102, and the decompression module 1103 may all be implemented by using software, or may be implemented by using hardware. For example, the following uses the obtaining module 1001 as an example to describe an implementation of the obtaining module 1001. Similarly, for implementations of the combination module 1002, the compression module 1003, the first obtaining module 1101, the second obtaining module 1102, and the decompression module 1103, refer to the implementation of the obtaining module 1001.

The module is used as an example of a software functional unit, and the obtaining module 1001 may include code run on a computing instance. The computing instance may include at least one of a physical host (computing device), a virtual machine, and a container. Further, there may be one or more computing instances. For example, the obtaining module 1001 may include code run on a plurality of hosts/virtual machines/containers. It should be noted that, the plurality of hosts/virtual machines/containers configured to run the code may be distributed in a same region (region), or may be distributed in different regions. Further, the plurality of hosts/virtual machines/containers configured to run the code may be distributed in a same availability zone (availability zone, AZ), or may be distributed in different AZs. Each AZ includes one data center or a plurality of data centers that are geographically close to each other. One region may usually include a plurality of AZs.

Similarly, the plurality of hosts/virtual machines/containers configured to run the code may be distributed in a same virtual private cloud (virtual private cloud, VPC), or may be distributed in a plurality of VPCs. One VPC is usually disposed in one region. For cross-region communication between two VPCs in a same region and between VPCs in different regions, a communication gateway needs to be disposed in each VPC, and interconnection between the VPCs is implemented through the communication gateway.

The module is used as an example of a hardware functional unit, and the obtaining module 1001 may include at least one computing device, for example, a server. Alternatively, the obtaining module 1001 may be a device implemented by using an application-specific integrated circuit (application-specific integrated circuit, ASIC), a programmable logic device (programmable logic device, PLD), or the like. The PLD may be implemented by a complex programmable logic device (complex programmable logic device, CPLD), a field-programmable gate array (field-programmable gate array, FPGA), a generic array logic (generic array logic, GAL), or any combination thereof.

A plurality of computing devices included in the obtaining module 1001 may be distributed in a same region, or may be distributed in different regions. The plurality of computing devices included in the obtaining module 1001 may be distributed in a same AZ, or may be distributed in different AZs. Similarly, the plurality of computing devices included in the obtaining module 1001 may be distributed in a same VPC, or may be distributed in a plurality of VPCs. The plurality of computing devices may be any combination of computing devices such as the server, the ASIC, the PLD, the CPLD, the FPGA, and the GAL.

It should be noted that, in another embodiment, any one of the obtaining module 1001, the combination module 1002, the compression module 1003, the first obtaining module 1101, the second obtaining module 1102, and the decompression module 1103 may be configured to perform any step in the data processing method. Steps implemented by the obtaining module 1001, the combination module 1002, the compression module 1003, the first obtaining module 1101, the second obtaining module 1102, and the decompression module 1103 may be specified as required. The obtaining module 1001, the combination module 1002, the compression module 1003, the first obtaining module 1101, the second obtaining module 1102, and the decompression module 1103 respectively implement different steps in the data processing method, to implement all functions of the data processing apparatus.

It can be clearly understood by a person skilled in the art that, for the purpose of convenient and brief description, for detailed working processes of the foregoing apparatuses and modules, refer to corresponding content in the foregoing method embodiments. Details are not described herein again.

An embodiment of this application provides a computing device. The computing device is configured to implement some or all functions of the data processing method provided in embodiments of this application. FIG. 12 is a diagram of a structure of a computing device according to an embodiment of this application. As shown in FIG. 12, the computing device 1200 includes a processor 1201, a memory 1202, a communication interface 1203, and a bus 1204. The processor 1201, the memory 1202, and the communication interface 1203 implement communication connections with each other through the bus 1204.

The processor 1201 may include a general-purpose processor and/or a dedicated hardware chip. The general-purpose processor may include a central processing unit (central processing unit, CPU), a microprocessor, or a graphics processing unit (graphics processing unit, GPU). For example, the CPU is a single-core (single-CPU) processor or a multi-core (multi-CPU) processor. The dedicated hardware chip is a hardware module capable of performing high-performance processing. The dedicated hardware chip includes at least one of a digital signal processor, an application-specific integrated circuit (application-specific integrated circuit, ASIC), a field-programmable logic gate array (field-programmable logic gate array, FPGA), or a network processor (network processor, NP). The processor 1201 may be an integrated circuit chip and has a signal processing capability. In an implementation process, some or all functions of the data processing method in this application may be implemented by using an integrated logic circuit of hardware in the processor 1201 or instructions in a form of software.

The memory 1202 is configured to store a computer program, and the computer program includes an operating system 1202a and executable code (namely, program instructions) 1202b. For example, the memory 1202 is a read-only memory, another type of static storage device that can store static information and instructions, a random access memory, another type of dynamic storage device that can store information and instructions, an electrically erasable programmable read-only memory, a compact disc read-only memory, other optical disk storage, optical disc storage (including a compact disc, a laser disc, an optical disc, a digital versatile disc, a Blu-ray disc, or the like), a magnetic disk storage medium, another magnetic storage device, or any other medium that can be used to carry or store expected executable code in a form of instructions or a data structure and that can be accessed by a computer. However, the memory is not limited thereto. For example, the memory 1202 is configured to store an egress port queue. For example, the memory 1202 exists independently, and is connected to the processor 1201 through the bus 1204. Alternatively, the memory 1202 and the processor 1201 are integrated together. The memory 1202 may store executable code. When the executable code stored in the memory 1202 is executed by the processor 1201, the processor 1201 is configured to perform some or all functions of the data processing method provided in embodiments of this application. For an implementation of performing the process by the processor 1201, refer to related descriptions in the foregoing embodiments. The memory 1202 may further include another software module like an operating system, or data for running a process.

The communication interface 1203 uses a transceiver module, for example, but not limited to a transceiver, to implement communication with another device or a communication network. For example, the communication interface 1203 may be any one or any combination of the following components with a network access function: a network interface (for example, an Ethernet interface) and a wireless network interface card.

The bus 1204 is any type of communication bus configured to implement interconnection between internal components (for example, the memory 1202, the processor 1201, and the communication interface 1203) in the computing device, for example, a system bus. In this embodiment of this application, an example in which the foregoing components in the computing device are interconnected through the bus 1204 is used for description. Optionally, the foregoing components in the computing device 1200 may be communicatively connected to each other in another connection manner other than the bus 1204. For example, the foregoing components in the computing device 1200 are interconnected through an internal logical interface.

It should be noted that the plurality of components may be separately disposed on chips independent of each other, or at least some or all of the components may be disposed on a same chip. Whether the components are independently disposed on different chips or are integrated and disposed on one or more chips usually depends on a requirement of a product design. This embodiment of this application imposes no limitation on specific implementations of the components. Descriptions of procedures corresponding to the accompanying drawings have respective focuses. For a part that is not described in detail in a procedure, refer to related descriptions of another procedure.

All or some of the foregoing embodiments may be implemented by using software, hardware, firmware, or any combination thereof. When software is used to implement embodiments, all or a part of embodiments may be implemented in a form of a computer program product. The computer program product that provides a program development platform includes one or more computer instructions. When these computer program instructions are loaded and executed on the computing device, all or some of functions of the data processing method provided in embodiments of this application are implemented.

In addition, the computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium stores the computer program instructions that provide the program development platform.

An embodiment of this application further provides a computing device cluster. The computing device cluster includes at least one computing device. The computing device may be a server, for example, a central server, an edge server, or a local server in a local data center. In some embodiments, the computing device may alternatively be a terminal device, for example, a desktop computer, a notebook computer, or a smartphone.

Optionally, for a structure of the at least one computing device included in the computing device cluster, refer to the computing device 1200 shown in FIG. 12. The memory 1202 in one or more computing devices 1200 in the computing device cluster may store same instructions for performing the data processing method.

In some possible implementations, the memory 1202 in the one or more computing devices 1200 in the computing device cluster may alternatively separately store some instructions for performing the data processing method. In other words, a combination of the one or more computing devices 1200 may jointly execute the instructions for performing the data processing method.

It should be noted that memories 1202 in different computing devices 1200 in the computing device cluster may store different instructions respectively used to perform some functions of the data processing apparatus. To be specific, instructions stored in the memories 1202 in different computing devices 1200 may implement functions of one or more of the obtaining module 1001, the combination module 1002, the compression module 1003, the first obtaining module 1101, the second obtaining module 1102, and the decompression module 1103.

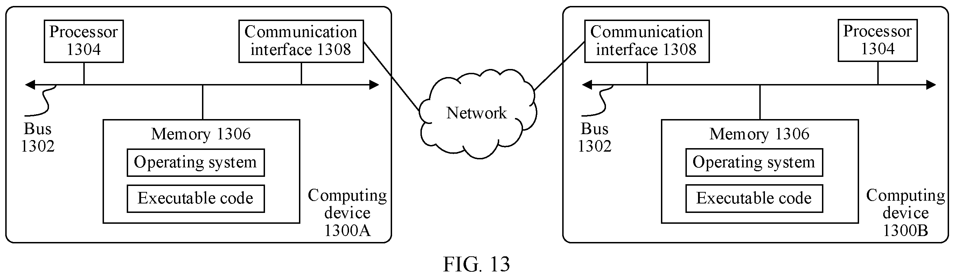

In some possible implementations, the one or more computing devices in the computing device cluster may be connected through a network. The network may be a wide area network, a local area network, or the like. FIG. 13 shows a possible implementation. As shown in FIG. 13, two computing devices 1300A and 1300B are connected through a network. Specifically, each computing device is connected to the network through a communication interface of the computing device. In this possible implementation, the computing devices 1300A and 1300B include a bus 1302, a processor 1304, a memory 1306, and a communication interface 1308. A memory 1306 in the computing device 1300A stores instructions for performing functions of the obtaining module 1001, the combination module 1002, and the compression module 1003. In addition, a memory 1306 in the computing device 1300B stores instructions for performing functions of the first obtaining module 1101, the second obtaining module 1102, and the decompression module 1103.

It should be understood that functions of the computing device 1300A shown in FIG. 13 may alternatively be implemented by a plurality of computing devices 1300. Similarly, functions of the computing device 1300B may alternatively be implemented by a plurality of computing devices 1300. In addition, a deployment manner of the modules configured to implement the data processing method in the computing device may alternatively be adjusted based on an application requirement.

An embodiment of this application further provides a computer-readable storage medium. The computer-readable storage medium is a non-volatile computer-readable storage medium. The computer-readable storage medium includes program instructions. When the program instructions are run on a computing device, the computing device is enabled to implement the data processing method provided in embodiments of this application.

An embodiment of this application further provides a computer program product including instructions. When the computer program product is run on a computer, the computer is enabled to implement the data processing method provided in embodiments of this application.

A person of ordinary skill in the art may understand that all or some of the steps of embodiments may be implemented by hardware or a program instructing related hardware. The program may be stored in a computer-readable storage medium. The storage medium may be a read-only memory, a magnetic disk, an optical disc, or the like.

It should be noted that information (including but not limited to user equipment information, personal information of a user, and the like), data (including but not limited to data used for analysis, stored data, displayed data, and the like), and signals in this application are used under authorization by the user or full authorization by all parties, and capturing, use, and processing of related data need to conform to related laws, regulations, and standards of related countries and regions. For example, the original data, the executable code, and the like in this application are obtained under full authorization.

In embodiments of this application, the terms "first", "second", and "third" are merely used for description, but cannot be understood as an indication or implication of relative importance. The term "at least one" means one or more, and the term "a plurality of" means two or more, unless otherwise expressly limited.

The term "and/or" in this application describes only an association relationship for describing associated objects and indicates that three relationships may exist. For example, A and/or B may indicate the following three cases: Only A exists, both A and B exist, and only B exists. In addition, the character "/" in this specification generally indicates an "or" relationship between the associated objects.

The foregoing descriptions are merely optional embodiments of this application, but are not intended to limit this application. Any modification, equivalent replacement, improvement, or the like made within the concept and principle of this application shall fall within the protection scope of this application.

## Claims

1. A data processing method, wherein the method comprises:
Obtaining a plurality of to-be-compressed data blocks;
combining the plurality of to-be-compressed data blocks; and
compressing the plurality of combined to-be-compressed data blocks, to obtain a data set with combine compression.

2. The method according to claim 1, wherein the plurality of to-be-compressed data blocks are sequentially sorted, and a coding partition of any one of the plurality of to-be-compressed data blocks comprises the any one to-be-compressed data block and all to-be-compressed data blocks that are in the plurality of to-be-compressed data blocks and that are sorted before the any one to-be-compressed data block.

3. The method according to claim 1 or 2, wherein the compressing the plurality of combined to-be-compressed data blocks comprises:
compressing the plurality of combined to-be-compressed data blocks based on forward coding.

4. The method according to any one of claims 1 to 3, wherein the obtaining a plurality of to-be-compressed data blocks comprises:
obtaining a plurality of to-be-written data blocks according to a data write instruction; and
obtaining the plurality of to-be-compressed data blocks based on the plurality of to-be-written data blocks.

5. The method according to claim 4, wherein the method further comprises:
storing the data set in a storage medium.

6. The method according to claim 5, wherein the method further comprises:
updating index information of the storage medium based on a location of the data set in the storage medium.

7. The method according to claim 6, wherein the index information further indicates that the data set is obtained through combine compression.

8. The method according to any one of claims 1 to 7, wherein the obtaining a plurality of to-be-compressed data blocks comprises:
obtaining a plurality of to-be-filtered data blocks; and
obtaining the plurality of to-be-compressed data blocks based on to-be-filtered data blocks comprising similar data in the plurality of to-be-filtered data blocks.

9. The method according to claim 8, wherein the obtaining the plurality of to-be-compressed data blocks based on to-be-filtered data blocks comprising similar data in the plurality of to-be-filtered data blocks comprises:
performing deduplication on the to-be-filtered data blocks comprising similar data, to obtain the plurality of to-be-compressed data blocks.

10. The method according to claim 9, wherein index information of a reserved to-be-filtered data block with deduplication further indicates that the reserved to-be-filtered data block is obtained through deduplication.

11. The method according to any one of claims 1 to 10, wherein index information of the to-be-compressed data blocks further indicates logical index numbers of the plurality of to-be-compressed data blocks.

12. A data processing method, wherein the method comprises:
obtaining index information of a to-be-decompressed target data set, wherein the target data set comprises one or more data blocks, and the target data set is obtained through combine compression;
obtaining the target data set based on the index information of the target data set; and
performing combine decompression on the target data set, to obtain a target data set with combine decompression.

13. The method according to claim 12, wherein the index information of the target data set further indicates a processing type of data in the target data set, and the performing combine decompression on the target data set, to obtain a target data set with combine decompression comprises:
when the index information of the target data set indicates that the target data set is obtained through combine compression, performing combine decompression on the target data set, to obtain the target data set with combine decompression.

14. The method according to claim 12 or 13, wherein the target data set is stored in a storage medium, both a primary index area and an online index area of the storage medium record index information, the primary index area records first index information of all data stored in the storage medium, the online index area records second index information, the first index information is obtained by updating the second index information, and the obtaining index information of a to-be-decompressed target data set comprises:
obtaining the index information of the target data set preferentially from the first index information recorded in the primary index area.

15. The method according to claim 14, wherein the method further comprises:
when the target data set fails to be obtained based on the first index information, obtaining the index information of the target data set from the second index information recorded in the online index area.

16. The method according to any one of claims 12 to 15, wherein the target data set is obtained according to a data read instruction.

17. The method according to claim 16, wherein the data read instruction instructs to read a target data block in the target data set, and the method further comprises:
obtaining index information of the target data block;
obtaining, based on the index information of the target data block, the target data block from the target data set with combine decompression; and
feeding back the target data block according to the data read instruction.

18. The method according to claim 17, wherein the index information of the target data block indicates a logical index number of the target data block, and the obtaining, based on the index information of the target data block, the target data block from the target data set with combine decompression comprises:
obtaining, based on the logical index number, the target data block from the target data set with combine decompression.

19. A data processing apparatus, wherein the apparatus comprises:
an obtaining module, configured to obtain a plurality of to-be-compressed data blocks;
a combination module, configured to combine the plurality of to-be-compressed data blocks; and
a compression module, configured to compress the plurality of combined to-be-compressed data blocks, to obtain a data set with combine compression.

20. The apparatus according to claim 19, wherein the plurality of to-be-compressed data blocks are sequentially sorted, and a coding partition of any one of the plurality of to-be-compressed data blocks comprises the any one to-be-compressed data block and all to-be-compressed data blocks that are in the plurality of to-be-compressed data blocks and that are sorted before the any one to-be-compressed data block.

21. The apparatus according to claim 19 or 20, wherein the compression module is specifically configured to compress the plurality of combined to-be-compressed data blocks based on forward coding.

22. The apparatus according to any one of claims 19 to 21, wherein the obtaining module is specifically configured to:
obtain a plurality of to-be-written data blocks according to a data write instruction; and
obtain the plurality of to-be-compressed data blocks based on the plurality of to-be-written data blocks.

23. The apparatus according to claim 22, wherein the compression module is further configured to store the data set in a storage medium.

24. The apparatus according to claim 23, wherein the compression module is further configured to update index information of the storage medium based on a location of the data set in the storage medium.

25. The apparatus according to claim 24, wherein the index information further indicates that the data set is obtained through combine compression.

26. The apparatus according to any one of claims 19 to 25, wherein the obtaining module is specifically configured to:
obtain a plurality of to-be-filtered data blocks; and
obtain the plurality of to-be-compressed data blocks based on to-be-filtered data blocks comprising similar data in the plurality of to-be-filtered data blocks.

27. The apparatus according to claim 26, wherein the obtaining module is specifically configured to perform deduplication on the to-be-filtered data blocks comprising similar data, to obtain the plurality of to-be-compressed data blocks.

28. The apparatus according to claim 27, wherein index information of a reserved to-be-filtered data block with deduplication further indicates that the reserved to-be-filtered data block is obtained through deduplication.

29. The apparatus according to any one of claims 19 to 28, wherein index information of the to-be-compressed data blocks further indicates logical index numbers of the plurality of to-be-compressed data blocks.

30. A data processing apparatus, wherein the apparatus comprises:
a first obtaining module, configured to obtain index information of a to-be-decompressed target data set, wherein the target data set comprises one or more data blocks, and the target data set is obtained through combine compression;
a second obtaining module, configured to obtain the target data set based on the index information of the target data set; and
a decompression module, configured to perform combine decompression on the target data set, to obtain a target data set with combine decompression.

31. The apparatus according to claim 30, wherein the decompression module is specifically configured to: when the index information of the target data set indicates that the target data set is obtained through combine compression, perform combine decompression on the target data set, to obtain the target data set with combine decompression.

32. The apparatus according to claim 30 or 31, wherein the target data set is stored in a storage medium, both a primary index area and an online index area of the storage medium record index information, the primary index area records first index information of all data stored in the storage medium, the online index area records second index information, the first index information is obtained by updating the second index information, and the first obtaining module is specifically configured to obtain the index information of the target data set preferentially from the first index information recorded in the primary index area.

33. The apparatus according to claim 32, wherein when the target data set fails to be obtained based on the first index information, the first obtaining module is further specifically configured to obtain the index information of the target data set from the second index information recorded in the online index area.

34. The apparatus according to any one of claims 30 to 33, wherein the target data set is obtained according to a data read instruction.

35. The apparatus according to claim 34, wherein the data read instruction instructs to read a target data block in the target data set;
the first obtaining module is further configured to obtain index information of the target data block;
the second obtaining module is further configured to: obtain, based on the index information of the target data block, the target data block from the target data set with combine decompression; and
the second obtaining module is further configured to feed back the target data block according to the data read instruction.

36. The apparatus according to claim 35, wherein the index information of the target data block indicates a logical index number of the target data block, and the second obtaining module is specifically configured to: obtain, based on the logical index number, the target data block from the target data set with combine decompression.

37. A computing device cluster, comprising at least one computing device, wherein each computing device comprises a processor and a memory, and the processor of the at least one computing device is configured to execute instructions stored in the memory of the at least one computing device, to enable the computing device cluster to perform the method according to any one of claims 1 to 18.

38. A computer program product comprising instructions, wherein when the instructions are run by a computing device cluster, the computing device cluster is enabled to perform the method according to any one of claims 1 to 18.

39. A computer-readable storage medium, comprising computer program instructions, wherein when the computer program instructions are executed by a computing device cluster, the computing device cluster performs the method according to any one of claims 1 to 18.
